(19) Europäisches Patentamt
European Patent Office
Office européen des brevets

(11) **EP 4 589 644 A1**

(12) **EUROPEAN PATENT APPLICATION**
published in accordance with Art. 153(4) EPC

(43) Date of publication:
**23.07.2025 Bulletin 2025/30**

(51) International Patent Classification (IPC):
***H01L 21/68*** (2006.01)

(21) Application number: **23864490.0**

(22) Date of filing: **26.07.2023**

(52) Cooperative Patent Classification (CPC):
**H01L 21/67; H01L 21/68; H01L 21/683;** Y02P 70/50

(86) International application number:
**PCT/CN2023/109214**

(87) International publication number:
**WO 2024/055756 (21.03.2024 Gazette 2024/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.09.2022 CN 202211117036**

(71) Applicant: **ACM Research (Shanghai), Inc.**
**Shanghai 201203 (CN)**

(72) Inventors:
• **ZHANG, Yiping**
**Shanghai 201203 (CN)**
• **WANG, Hui**
**Shanghai 201203 (CN)**

(74) Representative: **Osha BWB**
**2, rue de la Paix**
**75002 Paris (FR)**

(54) **WAFER CENTERING ADJUSTMENT APPARATUS AND ADJUSTMENT METHOD**

(57)     A wafer centering adjustment method, comprising: before a wafer (4) is etched, a wafer centering system (1) confirms whether the center of the wafer (4) coincides with the center of the first adsorption platform (3), and if not, the wafer centering system (1) corrects the position of the wafer (4). After the etching of the wafer (4) is completed, a wafer edge cleaning effect detection system (2) confirms whether the center of the wafer (4) coincides with the center of the first adsorption platform (3) during the process of etching, and obtains the second offset data. The wafer edge cleaning effect detection system (2) feeds back the second offset data to the wafer centering system (1). Before etching the next wafer, the wafer centering system (1) obtains the first offset data and preforms correction firstly, and then makes a secondary correction to the position of the wafer according to the second offset data obtained after the previous wafer is etched, thereby realizing a closed-loop control of the centering adjustment apparatus. In addition, the degree of coincidence between the center of the wafer and the center of the first adsorption platform is greatly improved by means of the secondary correction, thereby effectively guaranteeing the uniformity of the edge etching width of the wafer.

FIG.1

## Description

FIELD OF THE INVENTION

The present invention relates to the technical field of integrated circuits, and in particular to a water centering adjustment apparatus and an adjustment method.

BACKGROUND

As the technology nodes of integrated circuits continue to advance, semiconductor devices are getting closer and closer to the wafer edge. However, various defects transferred from the wafer edge become one of the main reasons that limit the device yield. During the process of device fabrication, the complex interaction among the thin film deposition, photolithography, etching, and chemical-mechanical polishing causes the unstable buildup of thin film on the wafer edge. The weak adhesion between these thin films and the inherent stress of the ultra-thick dielectric film in the edge region of the wafer may lead to serious peel defects, particle contaminations and other problems, further affecting the product yield.

To sum up, the importance of cleaning and etching of the wafer edge in the manufacturing process of complex thin film stacked chips has become increasingly prominent. During the manufacturing process, different chemical solutions can be used to effectively remove various types of dielectric films, metal films, organic material films, particle contaminations, etc. on the wafer edge, so as to avoid impact on the subsequent process, thereby improving the manufacturing yield of the chips.

However, if the uniformity of the edge etching width of the wafer cannot be strictly controlled, the effect of effective removal of thin films and contaminations cannot be achieved. Since the placement position of the wafer on the bearing platform depends on the transmission position of the wafer, if the transmission deviation occurs, the concentricity between the wafer and the bearing platform cannot be effectively guaranteed, thus affecting the uniformity of the edge etching width of the wafer.

SUMMARY

In view of the above problems, an object of the present invention is to provide a wafer centering adjustment apparatus and an adjustment method, so that the center of the wafer coincides with the center of the adsorption platform, and the uniformity of the edge etching width of the wafer is guaranteed.

In order to realize the above object, the present invention provides the following technical solutions:

A wafer centering adjustment apparatus, comprising a first adsorption platform, wherein the adjustment apparatus further comprises a wafer centering system and a wafer edge cleaning effect detection system;

the wafer centering system, located in the process chamber, used for measuring the first offset data when the center of the wafer deviating from the center of the first adsorption platform, and correcting the position of the wafer before etching based on the first offset data and the second offset data obtained after the previous wafer is etched, so that the center of the wafer coincides with the center of the first adsorption platform;

the wafer edge cleaning effect detection system, located outside the process chamber, used for measuring the edge etching width WE of the wafer after etching, obtaining the second offset data of the center of the wafer deviating from the center of the first adsorption platform based on the edge etching width WE, and feeding back the second offset data to the wafer centering system.

A wafer centering adjustment method, comprising the following steps:

the first adsorption platform adsorbing the wafer;

before the wafer is etched, the wafer centering system measures the first offset data of the center of the wafer deviating from the center of the first adsorption platform, and correct the position of the wafer based on the first offset data and the second offset data obtained after the previous wafer is etched, so that the center of the wafer coincides with the center of the first adsorption platform;

after the etching of wafer is completed, the wafer is transmitted to the wafer edge cleaning effect detection system;

the wafer edge cleaning effect detection system measuring the edge etching width of the wafer after etching, obtaining the second offset data of the center of the wafer deviating from the center of the first adsorption platform based on the edge etching width WE, and feeding back the second offset data to the wafer centering system.

Compared with the prior art, the present invention has the following beneficial effects:
Before the wafer is etched, the wafer centering system confirms whether the center of the wafer coincides with the center of the first adsorption platform, and if the wafer offsets, the wafer centering system corrects the position of the wafer.

After the etching of wafer is completed, the wafer is transmitted to the wafer edge cleaning effect detection system. The wafer edge cleaning effect detection system confirms whether the center of the wafer coincides with the center of the first adsorption platform during the process of wafer etching, and obtains the second offset data. The wafer edge cleaning effect detection system feeds back the second offset data to the wafer centering system.

Before etching the next wafer, the wafer centering system obtains the first offset data and corrects the position of the wafer firstly, and then makes a secondary correction to the position of the wafer according to the second offset data obtained after the previous wafer is etched, thereby realizing a closed-loop control of the centering adjustment apparatus. In addition, the two corrections greatly improve the degree of coincidence between the center of the wafer and the center of the first adsorption platform, effectively guaranteeing the uniformity of the edge etching width of the wafer.

BRIEF DESCRIPTION OF THE DRAWINGS

In order to more clearly explain the embodiments of the present invention or the technical solutions in the prior art, the drawings that need to be used in the description of the embodiments or the prior art will be briefly introduced below. It is obvious that the drawings in the following description are only some embodiments of the present invention, and for those of ordinary skill in the art, other drawings can be obtained according to these drawings on the premise of not paying creative labor.

FIG. 1 is a top view of a wafer centering system in a wafer centering adjustment apparatus according to embodiment 1 of the present invention;

FIG. 2 is a side view of a wafer centering system in a wafer centering adjustment apparatus according to embodiment 1 of the present invention;

FIG. 3 is a schematic structural diagram of a wafer edge cleaning effect detection system in a wafer centering adjustment apparatus according to embodiment 1 of the present invention;

FIG. 4 is a flowchart of a wafer centering adjustment method according to embodiment 2 of the present invention;

FIG. 5 is a periodic change relationship curve showing the angle and the readings of a displacement sensor of the present invention;

FIG. 6 is a first schematic diagram of a wafer deviating from the first adsorption platform of the present invention;

FIG. 7 is a second schematic diagram of a wafer deviating from the first adsorption platform of the present invention;

FIG. 8 a periodic change relationship curve showing the angle and the etching width of the present invention;

FIG. 9 is a schematic diagram of etching results after the wafer deviates from the first adsorption platform of the present invention.

[Description of FIG. No.]: a wafer centering system 1, a wafer edge cleaning effect detection system 2, a first adsorption platform 3, a wafer 4 and a driving module 5;

a first clamping member 10, a second clamping member 11, an elastic member 12, a recording unit 13, a data processing module 14 and rollers 15;

a second adsorption platform 20, a light emitting source 21 and a camera 22.

PREFERRED EMBODIMENTS OF THE INVENTION

In order to make the objects, features, and advantages of the present invention more obvious and easier to understand, the technical solutions in the embodiments of the present invention will be clearly and completely described below with reference to the accompanying drawings in the embodiments of the present invention. It is obvious that the embodiments described below are only some embodiments of the present invention, but not all embodiments. Based on the embodiments in the present invention, all other embodiments obtained by those of ordinary skill in the art on the premise of not paying creative labor belong to the scope of protection of the present invention.

In the description of the present invention, it is to be understood that when one component is considered to be "connected" to another component, the component may be directly connected to another component or there may be a component disposed in the center at the same time. When a component is considered to be "disposed" on another component, the component may be a component disposed directly on another component or there may be a component disposed in the center at the same time.

Hereinafter, the technical solutions of the present invention will be further described with reference to the accompanying drawings and specific embodiments.

First embodiment

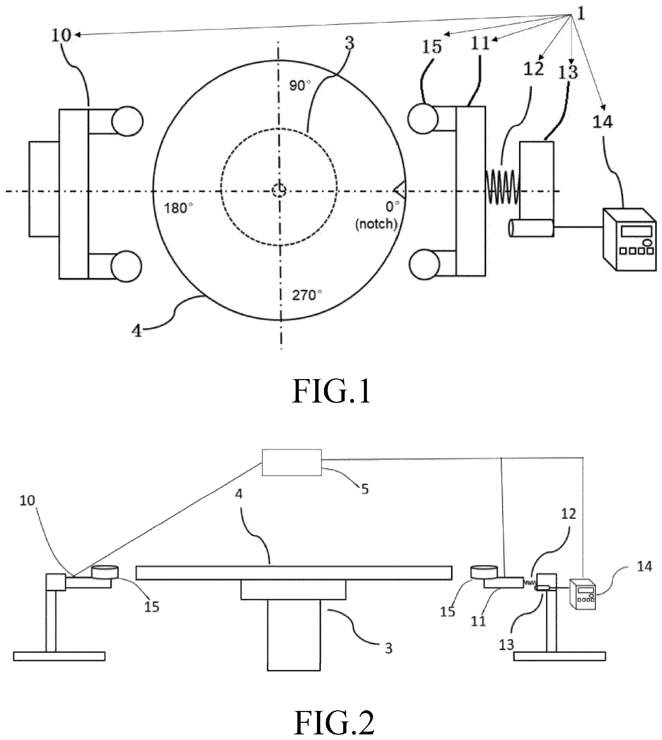

Referring to FIGS. 1 to 3, the present invention provides a wafer centering adjustment apparatus, wherein the adjustment apparatus comprises a first adsorption platform 3, a wafer centering system 1 and a wafer edge cleaning effect detection system 2. The wafer centering system 1 is located in the etched process chamber, and the wafer edge cleaning effect detection system 2 is located outside the etched process chamber.

Before the wafer 4 is etched, the wafer centering system 1 measures the first offset date that the center of the wafer 4 deviates from the center of the first adsorption platform 3. The wafer centering system 1 corrects the position of the wafer 4 based on the first offset data, such that the center of the wafer 4 coincides with the center of the first adsorption platform 3.

After the etching of the wafer 4 is completed, the wafer 4 is transmitted to the outside of the etched process chamber. The wafer edge cleaning effect detection system 2 measures the edge etching width WE of the wafer 4, and at the same time obtains the second offset data that the center of the wafer 4 deviates from the center of the first adsorption platform 3 based on the edge etching width WE, and feeds back the second offset data to the wafer centering system 1.

Before etching the next wafer the wafer centering system 1 corrects the position of the wafer based on the first offset data of the wafer and the second offset data of the previous wafer. In the context of the present application, the offset data obtained by the wafer centering system 1 before the etching of each wafer is collectively referred to as the first offset data, and the offset data obtained by the wafer edge cleaning effect detection system 2 after the etching of each wafer is collectively referred to as the second offset data.

Specifically, before the wafer 4 is etched, the wafer centering system 1 obtains the first offset data, and if the first offset data indicates that the wafer 4 exists offset situation, the wafer centering system 1 corrects the position of the wafer 4. After the etching of the wafer 4 is completed, in view of the possibility of errors in the measured data during the correction of the wafer centering system 1, the wafer edge cleaning effect detection system 2 reconfirms whether the center of the wafer 4 coincides with the center of the first adsorption platform 3 during the etching process, and obtains the second offset data. The wafer edge cleaning effect detection system 2 feeds back the second offset data to the wafer centering system 1. Before etching the next wafer, the wafer centering system 1 firstly obtains the first offset data and corrects the position of the wafer, and then make a secondary correction to the position of the wafer according to the second offset data obtained after the previous wafer is etched, thereby realizing a closed-loop control of the centering adjustment apparatus. In addition, the two corrections greatly improve the degree of coincidence between the center of the wafer and the center of the first adsorption platform 3, effectively guaranteeing the uniformity of the edge etching width of the wafer.

In an alternative embodiment, the wafer centering system 1 specifically comprises a clamping assembly, a measurement module, a driving module 5 and a data processing module 14. The clamping assembly limits the position of the wafer 4. When the wafer 4 is not deviated, the clamping assembly contacts the outer edge of the wafer 4, so that when the wafer 4 rotates, the clamping assembly does not hinder the movement of the wafer 4. When the wafer 4 is in a deviated state, the wafer 4 acts on the clamping assembly when rotating, and the clamping assembly moves and is connected to the measurement module. The measurement module measures the movement data generated by the clamping assembly and transmits the movement data to the data processing module 14.

When the center of the wafer 4 is deviated from the center of the first adsorption platform 3, the data processing module 14 sends a correction instruction to the driving module 5. The driving module 5 is connected to the clamping assembly and drives the clamping assembly to move based on the correction instruction, and the clamping assembly corrects the position of the wafer 4.

Further, the measurement module comprises an elastic member 12 and a recording unit 13, and the clamping assembly comprises a first clamping member 10 and a second clamping member 11. The first clamping member 10 and the second clamping member 11 are symmetrically arranged on two sides of the first adsorption platform 3. The symmetry axis is a straight line along the radial direction of the first adsorption platform 3 and passing through the center of the first adsorption platform 3. The second clamping member 11 is connected to the recording unit 13 by an elastic member 12.

When the wafer 4 is in a non-deviated state, the recording unit 13 records the initial compression amount of the elastic member 12.

When the wafer 4 is in a deviated state, during the rotation of the wafer 4, the deviation part of the wafer 4 pushes the second clamping member 11 to move towards the direction of the elastic member 12. The recording unit 13 records the date of compression amount. The data processing module 14 sends a correction instruction to the driving module 5 based on the data of compression amount, and the driving module 5 drives the first clamping member 10 and the second clamping member 11 to clamp the wafer 4 for movement based on the correction instruction, so that the center of the wafer 4 coincides with the center of the first adsorption platform 3. In actual production, a plurality of measurement points may be provided at the outer edge of the wafer 4, and the data of compression amount of a plurality of measurement points may be recorded, and the deviation part of the wafer may be judged by comparing the data of compression amount with the initial compression amount.

In an alternative embodiment, two cylindrical rollers 15 are mounted on the front ends of the first clamping member 10 and the second clamping member 11. When the center of the wafer is corrected by using two clamping members, the contact between four rollers 15 and four points of side surfaces of the wafer 4 are guaranteed. When the wafer 4 is rotated, the rollers 15 also rotate accordingly, so as to prevent damage to the wafer 4 from edge friction. The rollers 15 are preferably made of a material that is not easily deformed and has no impurities such as metals, for example, a ceramic material. In addition, the advantage of the four-point contact is that even if the notched part of the wafer 4 exactly comes into contact with one of the contact points, the two clamping members can push the wafer 4 to correct the center position of the wafer 4 by using the three remaining contact points, and there is no case where it is necessary to rotate the wafer 4 by a certain angle to avoid the notched position. In one alternative embodiment, the recording unit 13 is a displacement sensor, and the elastic member 12 is a spring, rubber, or the like. The centers of the first clamping member 10 and the second clamping member 11 are on the same horizontal line as the center of the first adsorption platform 3. The distance by which the spring is compressed can be read by the displacement sensor.

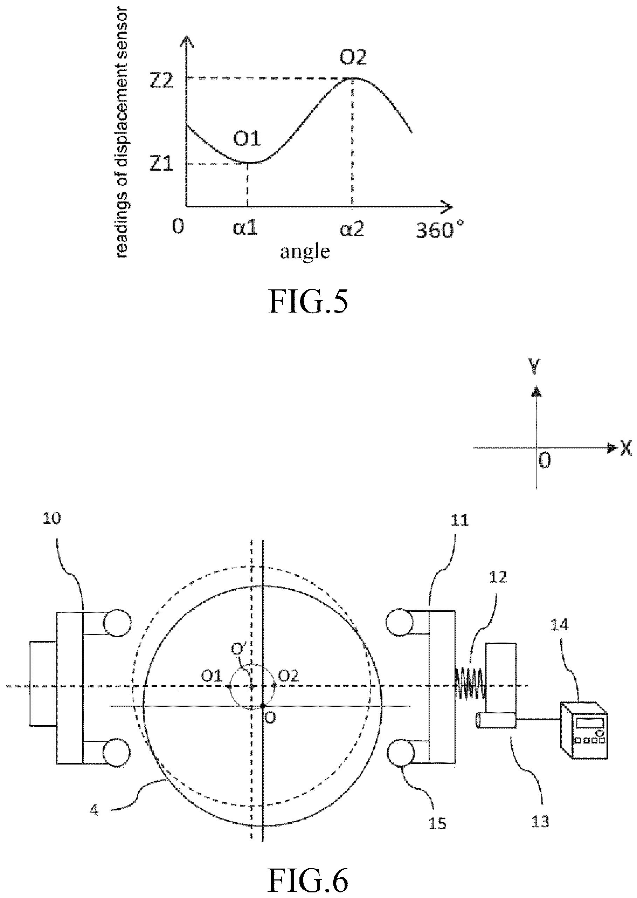

As shown in FIG. 5, four measurement points are arranged at uniform intervals on the wafer 4 along the circumferential direction of the wafer 4, that is, one measurement point is arranged at position 0°, 90 °, 180 °and 270 °respectively. When the wafer 4 is at position 0°, the corresponding reading of the displacement sensor is a. The wafer 4 rotates 90 ° firstly, the deviation part of the measurement point pushes the second clamping member 11 to move, and the corresponding reading of the displacement sensor is b. Similarly, when the wafer 4 continues to rotate 180° and 270° respectively, the corresponding readings of the displacement sensor at the measurement positions 180 ° and 270 °are c and d respectively. If the center of the wafer 4 coincides with the center of the first adsorption platform 3, the four values of a, b, c and d should be approximately equal within the error allowable range. If the wafer 4 is in a deviated state, the first clamping member 10 and the second clamping member 11 clamp the wafer 4 to move, so as to adjust the position of the wafer 4, so that the values of a, b, c and d are equal within the error allowable range, realizing the centering of the wafer 4. After the centering of the wafer 4 is completed, an etching process of the wafer edge will be performed in the process chamber.

In one alternative embodiment, when the center position of the wafer 4 is corrected by using the first clamping member 10 and the second clamping member 11, a plurality of measurement points are set, and the data of compression amount of a plurality of measurement points are recorded. For example, the wafer 4 can be rotated slowly for one revolution from the initial position 0°. The data of compression amount for one circle of 360 ° can be recorded, obtaining the periodic change relationship curve showing the angle and the readings of the displacement sensor as shown in FIG. 5. The data of the minimum value at point O1 and the maximum value at point O2 can be known in the figure. As shown in FIGS. 6 to 7, the line of the centers of the first clamping member 10 and the second clamping member 11 is defined as the X-axis, and the direction perpendicular to the X-axis is defined as the Y-axis. The point O in the figure indicates the actual center position of the wafer 4, and the point O' indicates the center position of the first adsorption platform 3, so that the wafer 4 rotates with point O' as the rotation center. When the center of wafer is at point O1, the reading of the displacement sensor appears a minimum value Z1. When the center of wafer is at point O2, the reading of the displacement sensor appears a maximum value Z2. And points O', O1 and O2 are on the same horizontal line with the centers of the two clamping members, thereby knowing the distance of OO', that is, the first offset amount of the center of the wafer 4 is (Z2-Z1)/2. Therefore, when the center position of the wafer 4 is corrected, the center of the wafer 4 can be rotated by a certain angle to the position at point O1 or point O2, and then the first clamping member 10 and the second clamping member 11 can be simultaneously moved to the right or left by a distance of (Z2-Z1)/2.

In the actual process, the accuracy of the recording unit 13 is insufficient, causing the recorded data to deviate from the actual situation, so it is necessary to further correct the position of the center of the wafer by using the wafer edge cleaning effect detection system 2. In one alternative embodiment, the wafer edge cleaning effect detection system 2 comprises a second adsorption platform 20, a light emitting source 21, a camera 22 and a calculation module.

After the edge etching of the wafer 4 is completed, the wafer 4 is conveyed onto the second adsorption platform 20 while the light emitting source 21 emits light, and the light rays are supplied to the surface of the wafer 4. The camera 22 obtains the edge pattern of the wafer 4 after the wafer 4 is etched. The calculation module calculates the edge etching width WE based on the edge pattern.

Further, the wafer edge cleaning effect detection system 2 comprises a judgment module. Four measurement points are arranged at uniform intervals along the circumferential direction of the wafer 4, that is, one measurement point is arranged at position 0°, 90 °, 180° and 270° respectively. The edge etching width WE corresponding to the measurement positions at 0°, 90 °, 180 ° and 270 ° are i, f, g and h respectively. Based on the values of i, f, g and h, the judgment module judges the offset situation of the wafer 4 with respect to the first adsorption platform 3 and feeds back the offset situation to the data processing module. If the four values of i, f, g and h are substantially equal within the allowable error range, it is considered that the concentricity of the wafer 4 with the first adsorption platform 3 during the edge etching process is good.

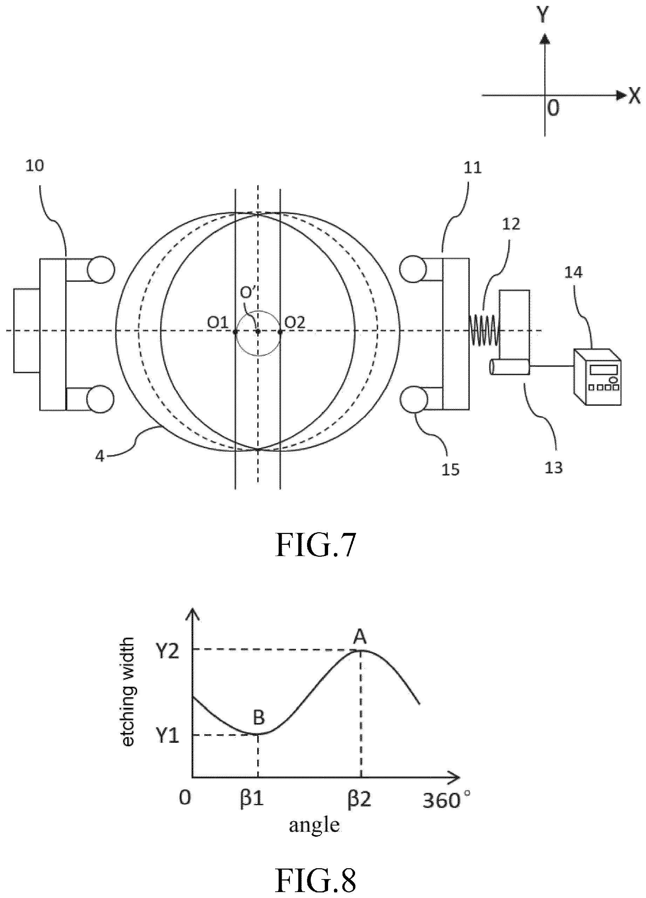

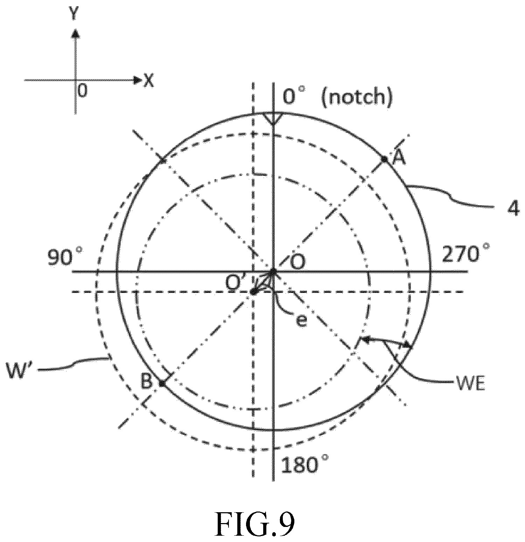

In an alternative embodiment, the wafer edge cleaning effect detection system 2 measures the edge etching width WE of the wafer for an entire circle of 360 ° after the wafer is etched. The periodic change relationship curve showing the angle and the etching width can be obtained as shown in FIG. 8. The data of the maximum value of point A and the minimum value of point B can be obtained in the figure. As shown in FIG. 9, the directions of defined X-axis and Y-axis are the same as those in FIGS. 6-7, in which a chain-dotted line indicates an etching edge formed after the etching is completed. A solid line indicates an actual position of the wafer 4, and a broken line indicates an ideal position W' when the wafer and the first adsorption platform are completely concentric. When the center O of the wafer 4 deviates from the center O' of the first adsorption platform 3 during etching, the point A and the point B must appear on the line between the two centers OO', and the distance of OO' is the offset amount e of the center of the wafer 4. Assume that the corresponding angle of point A is β2 and the etching width is Y2; while the corresponding angle of point B is β1 and the etching width is Y1, the following relational expression can be obtained:

$$\beta 2 - \beta 1 = 180\,°$$

$$Y2 - Y1 = 2e$$

Therefore, the offset amount e can be obtained, that is, OO' = e = (Y2-Y1)/2. At the same time, from the angle β2 corresponding to the point A, it is obtained that the offset amount of the center of the wafer 4 in the X-axis direction is eX = esin β2, and the offset amount of the center of the wafer 4 in the Y-axis direction is eY = ecos β2. Therefore, by the above calculation method, the specific second offset data can be obtained and fed back to the wafer centering system 1, so that the center of the wafer 4 can be further corrected.

Second embodiment

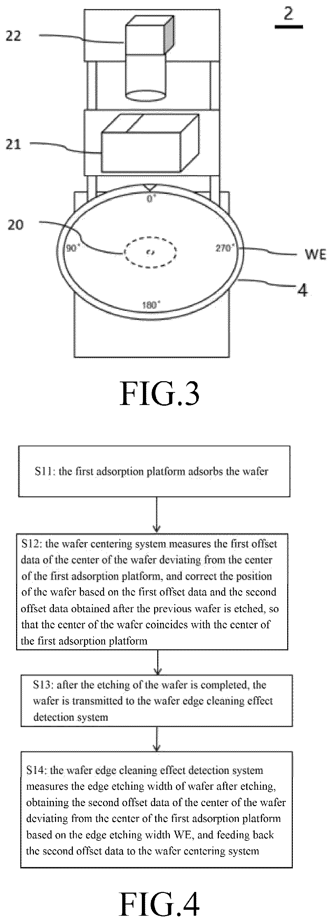

Referring to FIG. 4, the present embodiment provides a wafer centering adjustment method for the wafer centering adjustment apparatus according to the first embodiment, including the following steps:

S11: The first adsorption platform 3 adsorbs the wafer 4;

S12: Before the wafer 4 is etched, the wafer centering system 1 measures the first offset date when the center of the wafer 4 deviates from the center of the first adsorption platform 3. The position of the wafer 4 is corrected based on the first offset data and the second offset data obtained after the previous wafer is etched, so that the center of the wafer 4 coincides with the center of the first adsorption platform 3;

S13: After the etching of the wafer 4 is completed, the wafer 4 is transmitted to the wafer edge cleaning effect detection system 2;

S14: The wafer edge cleaning effect detection system 2 measures the edge etching width of the wafer 4 after the wafer 4 is etched, obtains the second offset data when the center of the wafer 4 deviates from the center of the first adsorption platform 3 based on the edge etching width WE, and feeds back the second offset data to the wafer centering system 1.

The wafer edge cleaning effect detection system 2 further detects the adjustment accuracy of the wafer centering system 1, and before etching the next wafer, the position of the wafer is corrected based on the first offset data of the wafer and the second offset data of the previous wafer, so as to effectively guarantee the uniformity of the edge etching width of the wafer.

In the above-described adjustment methods, the wafer centering system 1 further comprises a clamping assembly, a measurement module, a driving module 5, and a data processing module 14. The clamping assembly and the outer edge of the wafer 4 are always kept in contact when the wafer 4 is not deviated.

When the wafer 4 is in a deviated state, when the wafer 4 rotates, the deviated part of the wafer 4 pushes the clamping assembly to move. The measurement module measures the movement data and transmits the movement data to the data processing module 14. The data processing module 14 sends a correction instruction to the driving module 5, and the driving module 5 drives the clamping assembly to move based on the correction instruction. The clamping assembly clamps the wafer 4, and adjusts the position of the wafer 4, so that the center of the wafer 4 coincides with the center of the first adsorption platform 3.

Further, the measurement module comprises an elastic member 12 and a displacement sensor. The clamping assembly comprises a first clamping member 10 and a second clamping member 11. The first clamping member 10 and the second clamping member 11 are opposite to each other with the center of the first adsorption platform 3 as the symmetry axis, and the second clamping member 11 is connected to the displacement sensor by the elastic member 12.

Four measurement points are arranged at uniform intervals along the circumferential direction of the wafer 4, and when the wafer 4 rotates clockwise by 0 °, 90 °, 180 ° and 270 °, the corresponding readings of the displacement sensor are a, b, c and d respectively;

If c < a, d < b, it indicates that the center of the wafer 4 is deviated towards the first quadrant with respect to the center of the first adsorption platform 3, and the wafer 4 is offset by a certain distance to the third quadrant during correction;

Similarly, if a < c, d < b, it indicates that the center of the wafer 4 is deviated towards the second quadrant with respect to the center of the first adsorption platform 3;

If a < c, b < d, it indicates that the center of the wafer 4 is deviated towards the third quadrant with respect to the center of the first adsorption platform 3;

If c < a, b < d, it indicates that the center of the wafer 4 is deviated towards the fourth quadrant with respect to the center of the first adsorption platform 3.

Further, the wafer edge cleaning effect detection system 2 comprises a second adsorption platform 20, a light emitting source 21, a camera 22, a calculation module and a judgment module.

The second adsorption platform 20 adsorbs the wafer 4 after the wafer 4 is etched, the light emitting source 21 supplies the light rays to the surface of the wafer 4, and the camera 22 obtains the edge pattern of the wafer 4 after the wafer 4 is etched.

Four measurement points are arranged at uniform intervals along the circumferential direction of the wafer 4, and the edge etching width WE corresponding to the measurement positions at $0°$, $90°$, $180°$ and $270°$ are i, f, g and h respectively;

If $g < i$, $h < f$, it indicates that the center of the wafer 4 is deviated towards the first quadrant with respect to the center of the first adsorption platform 3;

If $i < g$, $h < f$, it indicates that the center of the wafer 4 is deviated towards the second quadrant with respect to the center of the first adsorption platform 3;

If $i < g$, $f < h$, it indicates that the center of the wafer 4 is deviated towards the third quadrant with respect to the center of the first adsorption platform 3;

If $g < i$, $f < h$, it indicates that the center of the wafer 4 is deviated towards the fourth quadrant with respect to the center of the first adsorption platform 3.

In an alternative embodiment, the wafer edge cleaning effect detection system 2 measures the edge etching width WE of the wafer for an entire circle of $360°$ after the wafer is etched.

If $e_x < 0$, $e_y > 0$, it indicates that the center of the wafer 4 is deviated towards the first quadrant with respect to the center of the first adsorption platform 3;

If $e_x > 0$, $e_y > 0$, it indicates that the center of the wafer 4 is deviated towards the second quadrant with respect to the center of the first adsorption platform 3;

If $e_x > 0$, $e_y < 0$, it indicates that the center of the wafer 4 is deviated towards the third quadrant with respect to the center of the first adsorption platform 3;

If $e_x < 0$, $e_y < 0$, it indicates that the center of the wafer 4 is deviated towards the fourth quadrant with respect to the center of the first adsorption platform 3.

The calculation module calculates the edge etching width WE according to the edge pattern and transmits the edge etching width WE to the judgement module. The judgement module forms the second offset data according to the edge etching width WE, and feeds back the second offset data to the wafer centering system 1. Before etching the next wafer, the wafer centering system 1 corrects the position of the wafer 4 according to the second offset data.

As described above, the above embodiments are merely used to describe the technical solutions of the present invention, and are not intended to limit the technical solutions. Although the present invention has been described in detail with reference to the aforementioned embodiments, those of ordinary skill in the art should understand that the technical solutions described in the aforementioned embodiments may be modified or some technical features may be equivalently replaced. However, these modifications or substitutions do not deviate the essence of the corresponding technical solutions from the spirit and scope of the technical solutions of each embodiment of the present invention.

**Claims**

1. A wafer centering adjustment apparatus, comprising a first adsorption platform (3), wherein the wafer centering adjustment apparatus further comprises a wafer centering system (1) and a wafer edge cleaning effect detection system (2);

   the wafer centering system (1), located in a process chamber, used for measuring the first offset data when the center of the wafer (4) deviating from the center of the first adsorption platform (3), and correcting the position of the wafer (4) before etching based on the first offset data and the second offset data obtained after the previous wafer is etched, so that the center of the wafer (4) coincides with the center of the first adsorption platform (3);
   the wafer edge cleaning effect detection system (2), located outside the process chamber, used for measuring the edge etching width WE of the wafer (4) after etching and obtaining the second offset data of the center of the wafer (4) deviating from the center of the first adsorption platform (3) based on the edge etching width WE, and feeding back the second offset data to the wafer centering system (1).

2. The wafer centering adjustment apparatus according to claim 1, wherein the wafer centering system (1) comprises a clamping assembly, a measurement module, a driving module (5) and a data processing module (14);

   the clamping assembly is connected to the measurement module, the clamping assembly is contacted with the outer edge of the wafer (4) when the wafer (4) is not deviated, and the driving module (5) is connected to the clamping assembly;
   the measurement module is used for measuring the movement data generated by the clamping assembly when the wafer (4) rotates and transmitting the movement data to the data processing module (14), the data processing module (14) is used for sending a correction instruction to the driving module (5) when the center of the wafer (4) deviates from the center of the first adsorption platform (3), the driving module (5) is used for driving the clamping assembly to move based on the correction instruction, and the clamping assembly is used for correcting the position of the wafer (4).

3. The wafer centering adjustment apparatus according to claim 2, wherein the measurement module comprises an elastic member (12) and a recording unit (13), the clamping assembly comprises a first clamping member (10) and a second clamping member (11), the first clamping member (10) and the second clamping member (11) are symmetrically arranged on both sides of the first adsorption platform (3), the second clamping member (11) is connected to the recording unit (13) by the elastic member (12), the recording unit (13) is used to record the compression amount of the elastic member (12);

when the wafer (4) is in a non-deviated state, the recording unit (13) records the initial compression amount;
when the wafer (4) is in a deviated state, the deviation part of the wafer (4) pushes the second clamping member (11) to move towards the direction of the elastic member (12) during the rotation of the wafer (4), the recording unit (13) records the data of compression amount, the data processing module (14) sends a correction instruction to the driving module (5) based on the data of compression amount, the driving module (5) drives the first clamping member (10) and the second clamping member (11) to clamp the wafer (4) for movement, so that the center of the wafer (4) coincides with the center of the first adsorption platform (3).

4. The wafer centering adjustment apparatus according to claim 3, wherein the recording unit (13) is a displacement sensor, four measurement points are arranged at uniform intervals along the circumferential direction of the wafer (4), and when the wafer (4) rotates to the positions of the four measurement points, the corresponding readings of the displacement sensor are a/b/c/d respectively, the first clamping member (10) and the second clamping member (11) are used for correcting the position of the center of the wafer (4), so that the values of a, b, c and d are equal within the allowable error range.

5. The wafer centering adjustment apparatus according to claim 3, wherein the clamping assembly is in four-point contact with the wafer (4), and the cylindrical rollers are mounted at contact positions of the first clamping member (10) and the second clamping member (11) with the wafer (4).

6. The wafer centering adjustment apparatus according to claim 3, wherein the recording unit (13) records the data of compression amount of the wafer (4) for one rotation, and obtains a periodic change relationship curve showing the angle and the readings of the displacement sensor, the minimum value of the data of compression amount is Z1 and the maximum value of the data of compression amount is Z2, so that the first offset data is (Z2 - Z1)/2.

7. The wafer centering adjustment apparatus according to claim 1, wherein the wafer edge cleaning effect detection system (2) comprises a second adsorption platform (20), a camera (22) and a calculation module;
the second adsorption platform (20) is used for adsorbing the wafer (4) after etching, the camera (22) is used for obtaining the edge pattern of the wafer (4) after etching, and the calculation module is used for calculating the edge etching width WE according to the edge pattern.

8. The wafer centering adjustment apparatus according to claim 7, wherein the wafer edge cleaning effect detection system (2) further comprises a judgement module;
four measurement points are arranged at uniform intervals along the circumferential direction of the wafer (4), the edge etching width WE corresponding to four measurement points are i/f/g/h respectively, the judgment module is used to judge the offset situation of the wafer (4) with respect to the first adsorption platform (3) based on the values of i/f/g/h, and feeds back the offset situation to the wafer centering system (1).

9. The wafer centering adjustment apparatus according to claim 7, wherein the wafer edge cleaning effect detection system (2) measures the edge etching width WE of the wafer (4) for whole circle after etching, and obtains a periodic change relationship curve showing the angle and the etching width;

the angle corresponding to the maximum value of point A is $\beta2$, the etching width is Y2, the angle corresponding to the minimum value of point B is $\beta1$, the etching width is Y1, and the offset amount of the center of the wafer (4) is e, then the following relational expression is obtained:

$$\beta2 - \beta1 = 180°$$

$$Y2 - Y1 = 2e$$

obtain e = (Y2-Y1)/2, and the offset amount of the center of the wafer (4) in the X-axis direction is $e_x$ = esin β2, and the offset amount of the center of the wafer (4) in the Y-axis direction is $e_y$ = ecos β2.

10. A wafer centering adjustment method, comprising the following steps:

the first adsorption platform (3) adsorbing the wafer (4);
before the wafer (4) is etched, the wafer centering system (1) measures the first offset data of the center of the wafer (4) deviating from the center of the first adsorption platform (3), and correct the position of the wafer (4) based on the first offset data and the second offset data obtained after the previous wafer is etched, so that the center of the wafer (4) coincides with the center of the first adsorption platform (3);
after the etching of the wafer (4) is completed, the wafer (4) is transmitted to the wafer edge cleaning effect detection system (2);
the wafer edge cleaning effect detection system (2) measuring the edge etching width of wafer (4) after etching, obtaining the second offset data of the center of the wafer (4) deviating from the center of the first adsorption platform (3) based on the edge etching width WE, and feeding back the second offset data to the wafer centering system (1).

11. The wafer centering adjustment method according to claim 10, wherein the wafer centering system (1) comprises a clamping assembly, a measurement module, a driving module (5) and a data processing module (14), when the wafer (4) is not deviated, the clamping assembly is in contact with the outer edge of the wafer (4);
when the wafer (4) is in a deviated state, when the wafer (4) rotates, the deviation part of the wafer (4) pushes the clamping assembly to move, the measurement module measures the movement data and transmits the movement data to the data processing module (14), the data processing module (14) sends a correction instruction to the driving module (5), the driving module (5) drives the clamping assembly to move based on the correction instruction, the clamping assembly clamps the wafer (4) such that the center of the wafer (4) coincides with the center of the first adsorption platform (3).

12. The wafer centering adjustment method according to claim 11, wherein the measurement module comprises an elastic member (12) and a displacement sensor, the clamping assembly comprises a first clamping member (10) and a second clamping member (11), the first clamping member (10) and the second clamping member (11) are symmetrically disposed at both sides of the first adsorption platform (3), the second clamping member (11) is connected to the displacement sensor by the elastic member (12);
during the rotation of the wafer (4), the deviation part of the wafer (4) pushes the second clamping member (11) to move towards the direction of the elastic member (12), the displacement sensor records the data of compression amount, based on the data of compression amount, the driving module (5) drives the first clamping member (10) and the second clamping member (11) to clamp the wafer (4) for movement, so that the center of the wafer (4) coincides with the center of the first adsorption platform (3).

13. The wafer centering adjustment method according to claim 12, wherein four measurement points are arranged at uniform intervals along the circumferential direction of the wafer (4), when the wafer (4) rotates to the positions of the four measurement points, the corresponding readings of the displacement sensor are a/b/c/d respectively;

if c < a, d < b, it indicates that the center of the wafer (4) is deviated towards the first quadrant with respect to the center of the first adsorption platform (3);
if a < c, d < b, it indicates that the center of the wafer (4) is deviated towards the second quadrant with respect to the center of the first adsorption platform (3);
if a < c, b < d, it indicates that the center of the wafer (4) is deviated towards the third quadrant with respect to the center of the first adsorption platform (3);
if c < a, b < d, it indicates that the center of the wafer (4) is deviated towards the fourth quadrant with respect to the center of the first adsorption platform (3).

14. The wafer centering adjustment method according to claim 12, wherein the displacement sensor records the data of compression amount of the wafer (4) for one rotation, and obtains a periodic change relationship curve showing the angle and the readings of the displacement sensor, the minimum value of the data of compression amount is Z1 and the maximum value of the data of compression amount is Z2, so that the first offset data is (Z2 - Z1)/2.

15. The wafer centering adjustment method according to claim 10, wherein the wafer edge cleaning effect detection system (2) comprises a second adsorption platform (20), a camera (22), a calculation module and a judgment module;

the second adsorption platform (20) adsorbs the wafer (4) after etching, the camera (22) obtains the edge pattern of the wafer (4) after etching, the calculation module calculates the edge etching width WE according to the edge pattern and transmits the edge etching width WE to the judgment module, and the judgment module forms the second offset data according to the edge etching width WE and feeds back the second offset data to the wafer centering system (1).

16. The wafer centering adjustment method according to claim 15, wherein four measurement points are arranged at uniform intervals along the circumferential direction of the wafer 4, and the edge etching width WE corresponding to the measurement points are i, f, g and h respectively;

if $g < i$, $h < f$, it indicates that the center of the wafer 4 is deviated towards the first quadrant with respect to the center of the first adsorption platform 3;

if $i < g$, $h < f$, it indicates that the center of the wafer 4 is deviated towards the second quadrant with respect to the center of the first adsorption platform 3;

if $i < g$, $f < h$, it indicates that the center of the wafer 4 is deviated towards the third quadrant with respect to the center of the first adsorption platform 3;

if $g < i$, $f < h$, it indicates that the center of the wafer 4 is deviated towards the fourth quadrant with respect to the center of the first adsorption platform 3.

17. The wafer centering adjustment method according to claim 15, wherein the wafer edge cleaning effect detection system (2) measures the edge etching width WE of the wafer (4) for whole circle after etching, and obtains a periodic change relationship curve showing the angle and the etching width;

the corresponding angle of the maximum value of point A is $\beta2$, the etching width is Y2, the corresponding angle of the minimum value of point B is $\beta1$, the etching width is Y1, and the offset amount of the center of the wafer (4) is e, then the following relational expression is obtained:

$$\beta2 - \beta1 = 180\,°$$

$$Y2 - Y1 = 2e$$

obtain $e = (Y2-Y1)/2$, and the offset amount of the center of the wafer (4) in the X-axis direction

is $e_x = e\sin \beta2$, the offset amount of the center of the wafer (4) in the Y-axis direction is $e_y = e\cos \beta2$;

if $e_x < 0$, $e_y > 0$, it indicates that the center of the wafer (4) is deviated towards the first quadrant with respect to the center of the first adsorption platform 3;

if $e_x > 0$, $e_y > 0$, it indicates that the center of the wafer (4) is deviated towards the second quadrant with respect to the center of the first adsorption platform 3;

if $e_x > 0$, $e_y < 0$, it indicates that the center of the wafer (4) is deviated towards the third quadrant with respect to the center of the first adsorption platform 3;

if $e_x < 0$, $e_y < 0$, it indicates that the center of the wafer (4) is deviated towards the fourth quadrant with respect to the center of the first adsorption platform 3.

FIG.1

FIG.2

FIG.3

S11: the first adsorption platform adsorbs the wafer

S12: the wafer centering system measures the first offset data of the center of the wafer deviating from the center of the first adsorption platform, and correct the position of the wafer based on the first offset data and the second offset data obtained after the previous wafer is etched, so that the center of the wafer coincides with the center of the first adsorption platform

S13: after the etching of the wafer is completed, the wafer is transmitted to the wafer edge cleaning effect detection system

S14: the wafer edge cleaning effect detection system measures the edge etching width of wafer after etching, obtaining the second offset data of the center of the wafer deviating from the center of the first adsorption platform based on the edge etching width WE, and feeding back the second offset data to the wafer centering system

FIG.4

FIG.5

FIG.6

FIG.7

FIG.8

FIG.9

## INTERNATIONAL SEARCH REPORT

| International application No. |
| --- |
| **PCT/CN2023/109214** |

**A. CLASSIFICATION OF SUBJECT MATTER**

H01L 21/68(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI, IEEE: 边缘, 沉积, 衬底, 处理, 对齐, 对正, 对中, 对准, 硅片, 基板, 基底, 晶片, 晶圆, 刻蚀, 历史, 前一, 清洗, 上一, 蚀刻, 周边, 周缘, edg+, clean+, wash+, wafer, silicon, substrate, history, prior, previous, align+

**C. DOCUMENTS CONSIDERED TO BE RELEVANT**

| Category* | Citation of document, with indication, where appropriate, of the relevant passages | Relevant to claim No. |
| --- | --- | --- |
| A | CN 112951733 A (CHANGXIN MEMORY TECHNOLOGIES, INC.) 11 June 2021 (2021-06-11) description, paragraphs 44-66, and figures 1-14 | 1-17 |
| A | CN 104979258 A (RAINTREE SCIENTIFIC INSTRUMENTS (SHANGHAI) CORP.) 14 October 2015 (2015-10-14) entire document | 1-17 |
| A | JP H0685038 A (TEL YAMANISHI K.K.) 25 March 1994 (1994-03-25) entire document | 1-17 |
| A | JP H05343501 A (DAIHEN CORP.) 24 December 1993 (1993-12-24) entire document | 1-17 |
| A | CN 101807537 A (DISCO CORP.) 18 August 2010 (2010-08-18) entire document | 1-17 |
| A | CN 114975154 A (BEIJING NAURA MICROELECTRONICS EQUIPMENT CO., LTD.) 30 August 2022 (2022-08-30) entire document | 1-17 |

☐ Further documents are listed in the continuation of Box C.    ☑ See patent family annex.

| | |
| --- | --- |
| *   Special categories of cited documents: <br> "A"   document defining the general state of the art which is not considered to be of particular relevance <br> "D"   document cited by the applicant in the international application <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
| --- | --- |
| **29 October 2023** | **01 November 2023** |

| Name and mailing address of the ISA/CN | Authorized officer |
| --- | --- |
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/109214**

| Patent document cited in search report | | | Publication date (day/month/year) | Patent family member(s) | | | Publication date (day/month/year) |
|---|---|---|---|---|---|---|---|
| CN | 112951733 | A | 11 June 2021 | None | | | |
| CN | 104979258 | A | 14 October 2015 | None | | | |
| JP | H0685038 | A | 25 March 1994 | None | | | |
| JP | H05343501 | A | 24 December 1993 | JP | 3223584 | B2 | 29 October 2001 |
| CN | 101807537 | A | 18 August 2010 | JP | 2010186863 | A | 26 August 2010 |
| CN | 114975154 | A | 30 August 2022 | None | | | |

Form PCT/ISA/210 (patent family annex) (July 2022)